# EUROPEAN PATENT SPECIFICATION

(11) **EP 2 157 589 B1**
(45) Date of publication and mention of the grant of the patent: **27.06.2012**
(21) Application number: 09177351.5
(22) Date of filing: 06.06.2002
(51) Int. Cl.: H01G 4/015, C23C 14/20, C23C 14/56, C23C 14/08, C23C 14/06, C23C 14/14, C23C 14/24

(54) **Method of manufacturing double surface metallized film.**
Verfahren zur Herstellung einer auf beiden Oberflächen metallisierten Schicht.
Procédé de fabrication d'un film à double surface métallisée.

(30) Priority: 08.06.2001 JP 2001173662; 29.03.2002 JP 2002096442
(43) Date of publication of application: 24.02.2010
(62) Divisional of application: 02733339.2
(73) Proprietor: Panasonic Corporation, Kadoma-shi Osaka 571-8501 (JP)
(72) Inventor: Shiota, Kohei, Osaka-shi Osaka 540-6207 (JP); Saito, Toshiharu, Osaka-shi Osaka 540-6207 (JP); Osamura, Kazumi, Osaka-shi Osaka 540-6207 (JP); Takeoka, Hiroki, Osaka-shi Osaka 540-6207 (JP); Nakatsubo, Kazuhiro, Osaka-shi Osaka 540-6207 (JP); Nishimori, Toshiyuki, Osaka-shi Osaka 540-6207 (JP); Shibuy, Masatoshi, Osaka-shi Osaka 540-6207 (JP); Sasaki, Toshihiro, Osaka-shi Osaka 540-6207 (JP); Okabe, Shigeo, Osaka-shi Osaka 540-6207 (JP)
(74) Representative: Grünecker, Kinkeldey, Stockmair & Schwanhäusser

(56) References cited:
- EP-A1- 0 421 040
- EP-A1- 0 741 397
- JP-A- 4 099 166
- US-A- 4 785 374

## Description

### TECHNICAL FIELD

The present invention relates to double surface metallized film used for capacitors and, more particularly, to a method of manufacturing double surface metallized film, and a capacitor using the same.

### BACKGROUND ART

A capacitor made from plastic film with metal vacuum deposited thereon (hereinafter referred to as metallized film capacitor) is conventionally widely employed. Particularly, metallized film capacitors using polypropylene (hereinafter referred to as PP) film which has excellent electrical characteristics (such as low dielectric loss, high withstand voltage, less change in dielectric constant due to temperature or frequency) are widely employed in various fields of applications ranging from small-sized electronic equipments represented by a portable equipment to large-sized industrial purposes such as a drive motor control for trains and a high-voltage phase advancer.

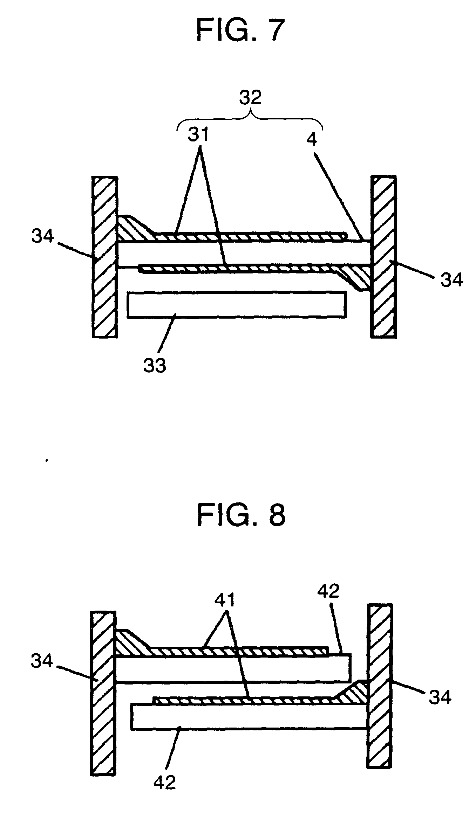

Fig. 8 is a sectional view of a conventional metallized film capacitor using PP film. Two sheets of PP film 42 with metal 41 vacuum deposited on one side are wound or laminated, to which a metal is thermally sprayed to form metallikon 34, thereby forming a capacitor. As the deposited metal 41, aluminum, zinc, or their mixture has been widely used, but in a case of using aluminum, an adhesive strength to the metallikon 34 is low, and when voltage is applied for a long period of time, there arises a problem such that a capacity is reduced due to oxidation and deterioration of aluminum. Accordingly, zinc or mixture of zinc and aluminum is recently employed in many cases.

As the deposited metal 41, as shown in Fig. 8, widely employed is a heavy edge structure wherein the deposited metal of capacity forming portion is decreased in thickness to enhance the self-restoring property (in a case of local dielectric breakdown of the film, the capacitor restores its function by eveporating and dispersing the adjacent deposited metal to cut off electrically), and the portion coming in contact with metallikon 34 is increased in thickness to enhance the strength of contact with metallikon 34.

In the conventional configuration, since two sheets of PP film with metal vacuum deposited on one side are used, a step of vacuum deposition is required for each of the films, resulting in an increase of a man power. The step of vacuum deposition can be halved if it is possible to vacuum deposit metal on both sides of the PP film (hereinafter referred to as double surface metallized PP film) in a single step of vacuum deposition and to realize a laminated structure (see Fig. 7) with a vacuum deposition-free polypropylene film (hereinafter referred to as laminating PP film).

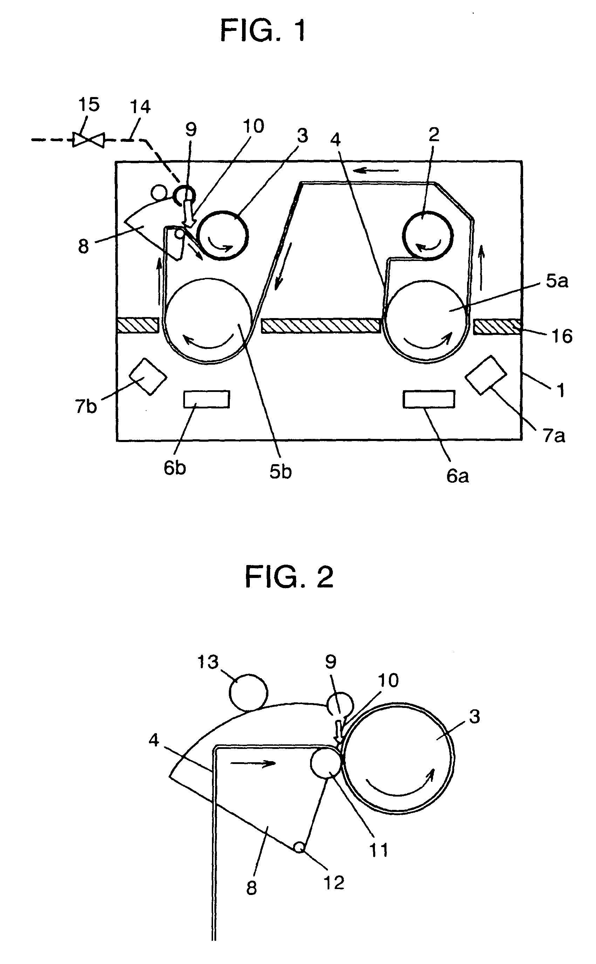

However, when metal is vacuum deposited on both sides, the film has to be once wound up to product roll 3 (see Fig. 1) in vacuum deposition apparatus I (see Fig. 1), and in that case, deposited metals on both sides become into contact with each other. PP film has low adhesive strength to the deposited metal because of low wettability, and also the tightning during the winding (stress accumulated in the product roll) of the product roll is very high. Therefore, the metals on both sides become bonded with each other, and there arises a problem such that the metals on both sides peel off each other (hereafter called blocking) when the film is unwound from the product roll in the next step (a step of slitting the vacuum deposited film or a step of winding the capacitor). As disclosed in U.S. Patent No. 3,895,129, it is known that the blocking is more remarkable when the deposited metal is zinc as compared with aluminum.

When a capacitor is manufactured by using double surface vacuum deposited PP film affected by the blocking, the double surface deposited metals peel off each other in the step of slitting or winding, causing the function as a capacitor electrode to be deteriorated and tanδ (dielectric tangent) to be increased. Accordingly, for using double surface vacuum deposited PP film for capacitors, it is absolutely required to solve the problem of the blocking.

From this point of view, manufacturing methods for suppressing the occurrence of the blocking have been proposed. For example, U.S. Patent No. 3,895,129 discloses a method of manufacturing vacuum depositing zinc on both sides of PP film, in which air is sprayed to the vacuum deposited surface on one side to oxidize the deposited metal surface, followed by winding up the film to a product roll.

Also, Japanese Patent Publication No. H7-62238 discloses a method of vacuum deposition of zinc, zinc alloy or other metal on both sides of synthetic resin film, in which oxidizing gas such as air and oxygen is injected into a film winding chamber, that is isolated by a partition wall from a vacuum depositing chamber, in a vacuum chamber. That is, a metal is first vacuum deposited on one side of the PP film, and then oxidizing gas is sprayed to the vacuum deposited surface to oxidize the vacuum deposited film. After that, the metal is vacuum deposited on another side of the film, and then oxidizing gas is sprayed to the vacuum deposited surface.

However, the problem of the blocking cannot be solved by using the manufacturing methods disclosed in U.S. Patent No. 3,895,129 and Japanese Patent Publication No. H7-62238 with respect to the double surface vacuum deposited PP film using zinc or mixture of zinc and aluminum.

Namely, in each of the manufacturing methods disclosed in U.S. Patent No. 3,895,129 and Japanese Patent Publication No. H7-62238, air or oxidizing gas is sprayed to the vacuum deposited surface of the PP film moving at a high speed, but since the PP film moving speed in the vacuum depositing process is generally 300 m to 1000 m per minute, the surface is just exposed to the air or oxidizing gas for extremely short time of less than 1/100 (one hundredth) second. In such a short period of time, in the case of vacuum deposited film formed of zinc or zinc-aluminum mixture, sufficient oxide layer is not formed. Accordingly, the manufacturing methods are not enough to solve the problem of the blocking.

Particularly, as a double surface vacuum deposited PP film for capacitors, PP film longer than 10,000 m is continuously vacuum deposited as a common method, but in a product roll of such a long film, tightning during the winding or stress is accumulated from outside to inside on the inner periphery (portion close to the winding core), and therefore, the blocking takes place with an insufficient oxide layer. If a capacitor is manufactured by using such double surface vacuum deposited PP film, there arises the problem of the increase in tanδ of the capacitor as described above.

Also, since the blocking is a phenomenon caused due to the deposited metals on a back and a front surface bond with each other, when the film is stored for a long period of time in a state of the product roll, there occurs problems such as the blocking due to the insufficient oxide layer and the increase of tanδ during the manufacturing of the capacitors.

Further, when a roll of the vacuum deposited film is affected by moisture during a long-time storage or a transportation, there arises a problem of secondary occurrence of a blocking. Such occurrence of the blocking due to moisture is remarkable in the case of zinc or zinc-aluminum deposited metal, and this is because zinc easily changes to oxide or hydroxide due to moisture.

Particularly, when PP film is used as the film, since it is poor in adhesive strength to the deposited metal as compared with other film, there is a problem such that the deposited metals on the front and back surface peel off from the film as they are bonded with each other due to moisture.

As described above, when a capacitor is manufactured by using the double surface metallized film affected by the blocking, there are problems such as lowering of withstand voltage due to wrinkles produced during slitting or winding operation and detereorating of tanδ as an electrode resistance is increased due to removal of the vacuum deposited film, oxidation or hydroxylation of the deposited metal.

Accordingly, when the double surface metallized film is stored or transported in a state of the roll, it is necessary to keep the storing place under low humidity as compared with conventional single-side metallized film, or to enclose the film together with a drying agent in the package.

The present invention addresses to provide a method of manufacturing an excellent double surface metallized PP film that is free from the blocking even when zinc or zinc-aluminum mixture is vacuum deposited on both sides of long PP film, and even in a case the film is exposed to moisture. Also, another object of the present invention is to provide an excellent capacitor that is less in man power in the production and free from increase in tanδ due to the blocking by using the double surface vacuum deposited PP film of the present invention.

### DISCLOSURE OF THE INVENTION

A method of manufacturing double surface metallized insulating film of the present invention includes a step of vacuum depositing of zinc or zinc-aluminum mixture on both sides of the insulating film, wherein oxidizing gas is sprayed to a vacuum deposited film on an inner surface of the insulating film wound up in a step of winding up to a product roll. Also, in a step of vacuum depositing of zinc or zinc-aluminum mixture is vacuum deposited on both sides of the insulating film, an oil layer is formed on at least one side of the deposited film, and an oxide layer is formed by exposing at least one side of the deposited film to oxygen-contained gas, or by spraying oxygen-contained gas to at least one side of the deposited film in a step of winding up the insulating film to a product roll. It is preferable to use PP film as an insulating film.

### BRIEF DESCRIPTION OF THE DRAWINGS

Fig. 1 is an explanatory view showing a method of manufacturing double surface metallized PP film in exemplary embodiment 1 of the present invention.
Fig. 2 is a partially enlarged view of a blowout port for spraying oxidizing gas in the exemplary embodiment 1 of the present invention.
Fig. 3 is an explanatory view showing a method of manufacturing double surface metallized PP film in exemplary embodiment 2 of the present invention.
Fig. 4 is a partially enlarged view of an oil layer forming portion in the exemplary embodiment 2 of the present invention.
Fig. 5 is a partially enlarged view of a nozzle of the oil layer forming portion in the exemplary embodiment 2 of the present invention.
Fig. 6 is an enlarged sectional view close to an oxygen exposing section in Fig. 3.
Fig. 7 is an explanatory view of a metallized film capacitor in the exemplary embodiment 1 of the present invention.
Fig. 8 is an explanatory view of a conventional metallized film capacitor.
Fig. 9 is an explanatory view of a metallized film capacitor in the exemplary embodiment 2 of the present invention.
Fig. 10 is an analysis chart of oil layer of the metallized film capacitor in the exemplary embodiment 2 of the present invention.
Fig. 11 is an analysis chart of oxide layer of a metallized film capacitor in the exemplary embodiment 1 of the present invention.

### DESCRIPTION OF THE PREFERRED EMBODIMENTS

### Exemplary embodiment 1

The exemplary embodiment 1 of the present invention will be described in the following with reference to Fig. 1, Fig. 2, and Fig. 11 where examples are using PP film as an insulating film.

In Fig. 1, PP film 4 is unwound from raw material roll 2 installed in vacuum deposition apparatus 1, and primary side deposited metal is formed on one side of the PP film 4 on primary side cooling can 5a using primary side aluminum evaporating source 6a and zinc evaporating source 7a. Then, secondary side deposited metal is formed on another side of the PP film 4 on secondary side cooling can 5b using secondary side aluminum evaporating source 6b and zinc evaporating source 7b. Partition wall 16 is disposed for the purpose of partitioning the vacuum deposition chamber so that a degree of vacuum in the vicinity of the vacuum depositing sources 5a, 5b, 6a, and 6b is not affected by gas or moisture adsorbed in the PP film 4 in the raw material roll 2. The partition wall 16 has been conventionally used.

Next, the PP film 4 with metal vacuum deposited on both sides is wound up to product roll 3 via roller 11 (see Fig. 2) disposed at follow-up drive section 8. In this case, oxidizing gas 10 from blowout port 9 disposed at the follow-up drive section 8 is sprayed to the inner surface of the PP film 4 to be wound up. The follow-up drive section 8, as shown in the enlarged view of Fig. 2, is a mechanism that follows up a radius of the product roll 3 that increases in size during vacuum deposition, by driving pinion gear 13, and rotates about rotary shaft 12. By keeping a distance between the roll 11 disposed on the follow-up drive section 8 and the product roll 3 constant, the PP film 4 can be uniformly wound up to the product roll 3 even in a case of vacuum deposition to a long continuous film.

The oxidizing gas 10 is sprayed from the blowout port 9 through piping 14, while the flow rate is adjusted by flow rate control valve 15, for example. In the configuration of the present invention, the oxidizing gas 10 sprayed is included in the product roll 3. Consequently, the deposited surfaces on both sides of the PP film 4 are exposed to the oxidizing gas 10 for a long time, and thereby, oxide layer is reliably formed. In this way, it is possible to prevent the blocking of vacuum deposited surfaces on both sides of the film.

The installing position of the blowout port 9 is not limited in particular provided that oxidizing gas 10 can be sprayed to an inner side of the winding. For example, in the case of vacuum deposition on long PP film 4 exceeding 10,000 m, it is desirable to install the blowout port on the follow-up drive section 8. That is, even when the radius of the product roll 3 is increased during vacuum deposition, the oxidizing gas 10 can be sprayed with a distance and an angle kept constant. Therefore, reliable blocking preventing effect can be obtained over an entire surfaces of the long PP film 4.

Fig. 7 is a sectional view of a double surface vacuum deposited PP film capacitor. The PP film capacitor includes double surface vacuum deposited PP film 32 and laminating PP film 33, wherein an electrode is led out by means of metallikon (thermally sprayed metal) 34 bonding to vacuum deposited electrode 31.

Next, blocking of double surface vacuum deposited PP film 32 manufactured in the exemplary embodiment 1 will be described in comparison with the prior art.

As the exemplary embodiment, double surface vacuum deposited PP films 32 as described below is manufactured by using PP film 4 of 4 µm thick and 15,000 m long.

### Exemplary embodiment 1 - 1:

Zinc is vacuum deposited on both sides of the PP film 4, and oxygen is sprayed by the method shown in Fig. 1 before winding up the PP film 4 to the product roll 3.

### Exemplary embodiment 1 - 2:

Zinc-aluminum mixture is vacuum deposited on both sides of the PP film 4, and air is sprayed by the method shown in Fig. 1 before winding up the PP film 4 to the product roll 3.

### Exemplary embodiment 1 - 3:

Zinc-aluminum mixture is vacuum deposited on both sides of the PP film 4, and oxygen is sprayed by the method shown in Fig. 1 before winding up the PP film 4 to the product roll 3.

Next, after taking the product roll 3 out of the vacuum deposition apparatus, double surface vacuum deposited PP film 32 at the outermost periphery and the innermost periphery of the product roll 3 were unwound and sampled, then the peeled state of the deposited metal 31 was observed using a transmission microscope having a magnification of 50 and photographed. The photograph was digitally processed by a computer, by binary-coding a portion with the deposited metal 31 peeled off and a portion being free from the peeled off to obtain a peeling rate of the deposited metal 31 by percentage. For the comparison, double surface vacuum deposited PP films based on the prior art, the peeling rates were obtained with respect to the following samples.

### Prior art 1 - 1:

Zinc is vacuum deposited on both sides of a PP film 4, and the PP film 4 is wound up to the product roll 3 woithout any treatment.

### Prior art 1 - 2:

Zinc-aluminum mixture is vacuum deposited on both sides of the PP film 4, and air is sprayed by the method shown in Fig. 1 of Japanese Patent Publication No. H7-62238 before winding up the PP film 4 to the product roll 3.

### Prior art 1 - 3:

Zinc-aluminum mixture is vacuum deposited on both sides of the PP film 4, and oxygen is sprayed by the method shown in Fig. 1 of Japanese Patent Publication No. H7-62238 before winding up the PP film 4 to the product roll 3.

The peeling rates of the deposited metal on each sample are shown in Table 1. In the present exemplary embodiment, the peeling rate of the deposited metal is very low even at the inner periphery of the product roll 3 where stresses are accumulated, and it is shown that an excellent double surface vacuum deposited PP film that cannot be obtained by the prior art can be produced.

**Table 1**

| | Oxidizing gas | Vacuum deposited metal | Peeling rate of deposited metal (%) | |
|---|---|---|---|---|
| | | | Outermost periphery of product roll | Innermost periphery of product roll |
| Exemplary embodiment 1 - 1 | Oxygen | Zinc | 0.3 | 0.8 |
| Exemplary embodiment 1 - 2 | Air | Zinc+Aluminum | 0.4 | 0.9 |
| Exemplary embodiment 1 - 3 | Oxygen | Zinc+Aluminum | 0.0 | 0.1 |
| Prior art 1 - 1 | None | Zinc | 6.2 | 38.6 |
| Prior art 1 - 2 | Air | Zinc+Aluminum | 2.2 | 8.3 |
| Prior art 1 - 3 | Oxygen | Zinc+Aluminum | 0.8 | 4.8 |

Next, capacitors (10 uF) shown in Fig. 7 are produced by winding the double surface vacuum deposited PP film 32 manufactured in the exemplary embodiment 1 and the laminating PP film 33, and, as an example of capacitor characteristics in the present exemplary embodiment, tanδ at 1 kHz is measured.

In each of the capacitors, film at the innermost periphery of the product roll 3 was used as the double surface vacuum deposited PP film 32.

The results are shown in Table 2. Tanδ of the capacitors based on the prior art become increased because of increase in serial equivalent resistance due to the peeling of the electrodes, while tanδ of the capacitors based on the present exemplary embodiment are low, showing excellent characteristics.

**Table 2**

| | tanδ |
|---|---|
| Exemplary embodiment 1 - 1 | 0.05 |
| Exemplary embodiment 1 - 2 | 0.05 |
| Exemplary embodiment 1 - 3 | 0.03 |
| Prior art 1 - 1 | 0.48 |
| Prior art 1 - 2 | 0.18 |
| Prior art 1 - 3 | 0.15 |

In the exemplary embodiment 1, the PP film 4 of 4 µm thick is used, and similar effects are also obtained in using other films of different thickness.

Also, the exemplary embodiment of the present invention is shown in Fig. 1 and Fig. 2, but the exemplary embodiment is not limited to these. Similar effects can be obtained by using a manufacturing method wherein oxidizing gas 10 is sprayed to the inner side of the PP film wound up to the product roll 3 in the vacuum depositing process in which zinc or zinc-aluminum mixture is vacuum deposited on both sides of the PP film 4 unwound from the raw material roll 2.

Also, oxygen and air are shown as oxidizing gas 10, but the present exemplary embodiment is not limited to these gas. Similar effects can be obtained by using ozone or other oxidizing gas, or gas that forms a passive state on the surface of the deposited metal. Further, in the above description, PP film is described as an example of the insulating film, but the manufacturing method of the present invention can be effectively applied to various kinds of insulating films other than PP film such as polyethylene telephthalate, polyethylene naphthalate, polyamide, and other insulating films.

### Exemplary embodiment 2

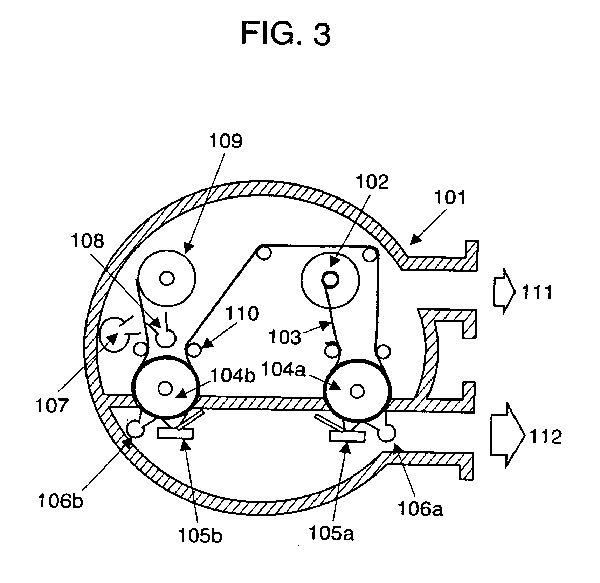

The exemplary embodiment 2 of the present invention will be described in the following with reference to Fig. 3 to Fig. 6, and Figs. 9 to Fig. 11.

Fig. 3 is a sectional view of a double surface metallized film manufacturing apparatus in the exemplary embodiment 2 of the present invention.

Metal is vacuum deposited on a front and a back surfaces of film 103 from aluminum evaporating source 105a, 105b and zinc evaporating source 106a, 106b when the film 103 unwound from unwinding section 102 in vacuum chamber 101 passes through cooling cans 104a and 104b. Then, oil layer is formed on the film 103 at oil layer forming section 107, and after the film is exposed to oxygen at oxygen exposure section 108, it is wound up by winding section 109 to be a raw material roll of a double surface metallized film. In Fig. 3, reference numeral 110 stands for an intermediate roll for film transportation, and reference numerals 111, 112 stand for an evacuation by a vacuum pump. Also, the aluminum evaporating source 105a, 105b and zinc evaporating source 106a, 106b can evaporate only aluminum, only zinc, and also, a mixture of aluminum and zinc depending on the purpose.

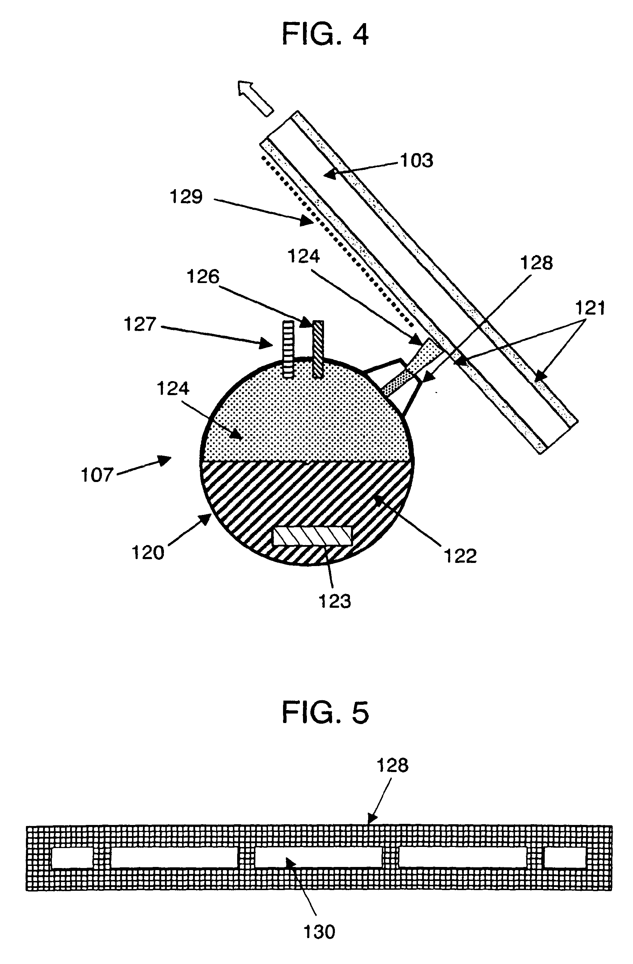

Fig. 4 is an enlarged sectional view in a vicinity of the oil layer forming section 107. Oil 122, heater 123, temperature sensor 126, and pressure sensor 127 are housed in a cylindrical oil tank 120. The oil 122 heated by the heater 123 spouts from nozzle 128 in the form of oil vapor 124, and thereby, oil layer 129 is formed on vacuum deposited film 121 on the film 103 that moves in a direction shown by the arrow. The temperature sensor 126 and the pressure sensor 127 are disposed for monitoring the temperature and pressure in the oil tank 120. Particularly, in a step of metallizing a long film, the amount of oil spouted during vacuum deposition is kept constant by the pressure sensor 127, and thereby, the oil layer can be uniformly formed on the vacuum deposited film 121.

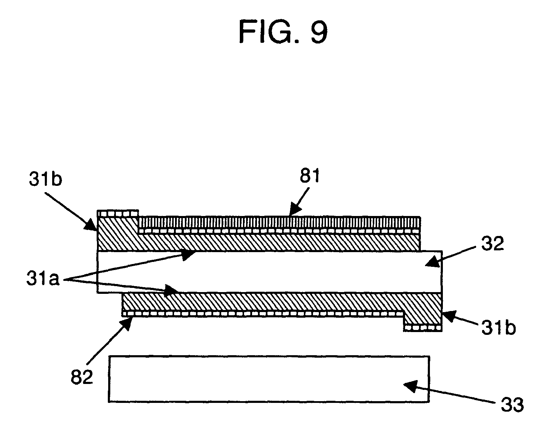

Fig. 5 shows a shape of nozzle 128. Oil vapor spouts from slit 130 disposed in the nozzle 128 to form oil layer on the film 103 (not shown). By disposing the slit 130 intermittently as shown in Fig. 5, the oil layer can be formed only on capacitance forming portions of the metallized film (refer to 81 in Fig. 9).

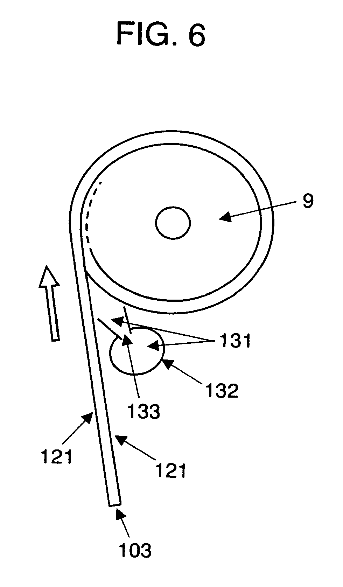

Fig. 6 is an enlarged sectional view in a vicinity of the oxygen exposure section 108. Gas 131 containing oxygen is introduced into cylindrical pipe 132 from outside the vacuum chamber (not shown), and the gas is sprayed from holes 133 in the pipe 132 to the vacuum deposited film 121 on the inner side of the film 103 to be wound, and in this way, the vacuum deposited film can be exposed to oxygen for a long period of time. Although it is not shown in Fig. 6, the holes 133 are formed at equal intervals over a entire width of the film.

The evaluation results of the blocking of the double surface metallized film in the exemplary embodiment 2 of the present invention are described in the following. Double surface metallized films shown in Table 3 are manufactured using the manufacturing apparatus shown in Fig. 3 with use of PP film of 6 µm thick and 520 mm wide. Each of a length of the vacuum deposited film is 3000 m. The vacuum deposition was executed so as to make the resistance of the vacuum deposited film to be 12 Ω per unit area.

The double surface metallized films manufactured in this way are keft in an atmosphere of a temperature of 40°C and a relative humidity of 60 % for 20 days in a state of an raw material roll. Then, the films are cut by a slitter and checked for an existtence of wrinkling, and also, the resistance of the vacuum deposited films are measured. The results are shown in Table 3.

**Table 3**

| | Deposited metal | Oil layer | Exposure atmosphere | Wrinkling due to slitting | Resistance of vacuum deposited film (Ω) |
|---|---|---|---|---|---|
| Exemplary embodiment 2 - 1 | Aluminum + Zinc oil | Silicone | Oxygen | No | 12 |
| Exemplary embodiment 2 - 2 | Aluminum + Zinc oil | Silicone | Air | No | 17 |
| Exemplary embodiment 2 - 3 | Aluminum + Zinc | Fluoro-carbon Oil | Oxygen | No | 12 |
| Exemplary embodiment 2 - 4 | Aluminum + Zinc | Paraffin Oil | Oxygen | No | 15 |
| Exemplary embodiment 2 - 5 | Zinc | Silicone oil | Oxygen | No | 13 |
| Prior art 2 - 1 | Aluminum + Zinc | None | Oxygen | Occured | 23 |
| Prior art 2 - 2 | Zinc | None | Oxygen | Occured | 42 |
| Comparative example | Aluminum Silicone + Zinc | oil | None | Occured | 28 |

As is obvious from Table 3, in a case of double surface metallized film in the prior art and the comparative example, wrinkles are produced during slitting operation due to the blocking, and the resistance of the vacuum deposited film is increased, while in a case of the exemplary embodiment, wrinkles does not occurr, and also, an increase of the resistance is suppressed. Particularly, in a case where the silicone oil or the fluoro-carbon oil is used for the oil layer, excellent results that show no increase in the resistance can be obtained.

Next, a metallized film capacitor shown in Fig. 9 is manufactured by using the double surface metallized film in the exemplary embodiment 2 - 1 and the prior art example 2 - 1. In Fig. 9, double surface metallized film 32 with metal 31a, 31b deposited on both sides and laminating PP film 33 are wound. Also, oil layer 81 and oxide layer 82 are formed on the double surface metallized film 32 by the process disclosed in the present exemplary embodiment.

As to the metallized film capacitor manufactured as recited above, tests were conducted with respect to tanδ at 1 kHz and withstand voltage at 60 Hz. In the withstand voltage test, the voltage causing short-circuitting of the capacitor is decided as the withstand voltage, where the voltage applied to the capacitor is increased by 50V per minute at an ambient temperature of 70°C. The results are shown in Table 4.

In a case of the capacitor of the prior art 2-1, tanδ is high due to the blocking, and also, the withstand voltage is low due to the wrinkles produced during the slitting operation. On the other hand, the capacitor of the present exemplary embodiment is excellent in tanδ and withstand voltage.

**Table 4**

| | tanδ (%) | Withstand voltage (AC, V) |
|---|---|---|
| Exemplary embodiment 2-1 | 0.05 | 1350 |
| Prior art 2-1 | 0.18 | 1050 |

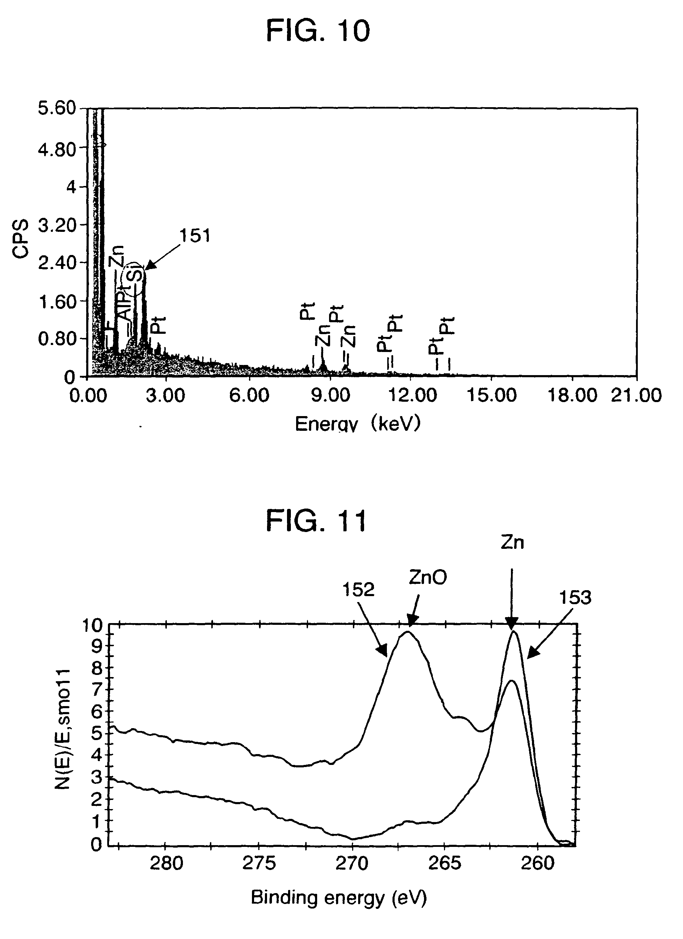

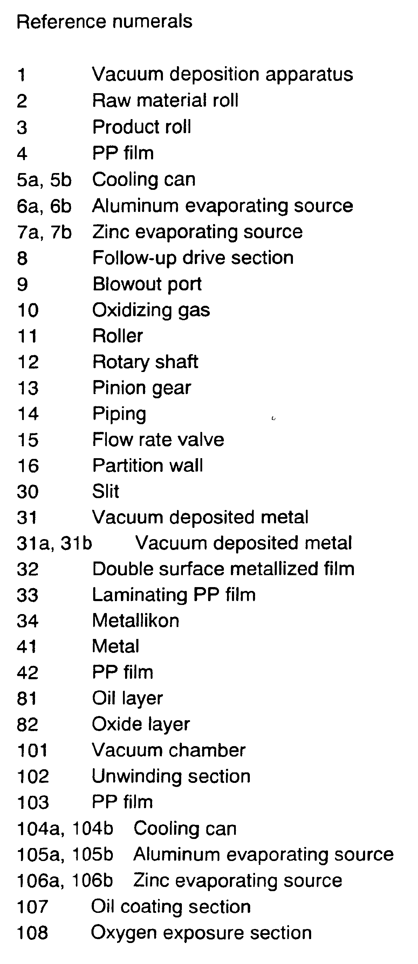

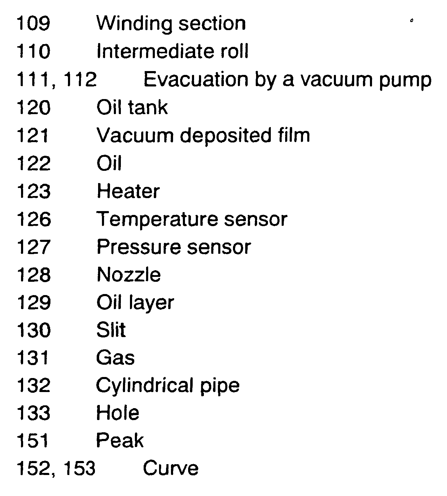

The existence of the oil layer in the present invention can be observed, for example, by using an energy dispersion type X-ray analyzer attached to an electron microscope after sampling double surface metallized film from the capacitor and measuring the deposited metal as it is, or extracting the oil using a proper solvent and condensing the solution. As an example, a result of an analysis of the metallized film capacitor of the exemplary embodiment 2 are shown in Fig. 10. In the figure, the abscissa shows the characteristic X-ray energy of the elements consisting of the double surface metallized film, and the ordinate shows the strength of each characteristic X-ray. The peak shown by circle 151 in the figure corresponds to silicone element, representing the existence of the oil layer composed of silicone oil.

Also, the existence of oxide layer in the present invention can be observed, for example, by analyzing the surface of the deposited film using X-ray photoelectron spectroscopy (hereinafter referred to as ESCA). As an example, a resuls of an analysis of the metallized film capacitor of the exemplary embodiment 1 are shown in Fig. 11. In Fig. 11, the abscissa shows a binding energy of zinc of the deposited metal, and a peak is detected at about 262 eV in a case of zinc metal, and at about 267 eV in a case of zinc oxide. Curve 152 in Fig. 11 is a result of an analysis of the vacuum deposited film surface, and curve 153 is a result of an internal portion of the deposited film that is obtained by removing the vacuum deposited film surface by etching. The curve 152 of the vacuum deposited film surface has a large peak of zinc oxide, showing the existence of the oxide layer.

The manufacturing apparatus shown in Figs. 3 to 6 is shown as an example in the exemplary embodiment 2, but the manufacturing apparatus for the present invention is not limit to this apparatus. Similar effects can be obtained by using a manufacturing apparatus for double surface metallized film comprising a metal depositing section for forming a deposited metal film on both sides of the film, an oil layer forming section for forming oil layer on at least one side of the deposited films formed by the metal depositing section, and an oxygen exposure section for exposing the deposited film surface on at least one side of the vacuum deposited films formed by the metal depositing section to an oxygen-contained atmosphere.

For example, with the arrangement in Fig. 3, the film passes through the oxygen exposure section after passing through the oil layer forming section, but similar effects can also be obtained by exchanging the position of the sections. Also, the oil layer formed surface can be either one of the same surface or opposite surface to the surface exposed to oxygen. This is because when the double surface metallized film is wound up at the winding section 109 of Fig. 3, the deposited films on the front surface and on the back surface come into contact with each other via the oil layer, and therefore, the influence of moisture can be suppressed against both surfaces. Naturally, it is also possible to form the oil layer on both surfaces.

Also, in Fig. 4, oil vapor is spouted from slits at the oil layer forming section, however, spouting holes at equal intervals may be provided instead of the slits.

Also, in Fig. 3, oxygen or air is sprayed at the oxygen exposure section, but similar effects can be obtained by exposing the film to an oxygen-containing atmosphere by other method. For example, a casing filled with oxygen-containing gas may be provided in the vacuum chamber, through which the film is passed to expose the deposited film 121 to oxygen.

Further, an example of a sectional view of a metallized film capacitor in the exemplary embodiment is shown in Fig. 9, but the present invention is not limited to the example. For example, similar effects can be obtained even when the deposited films 31a, 31b have uniform thickness instead of heavy edge structures.

### Exemplary embodiment 3

In order to study the influences of surface conditions of PP film 4, PP films 4 having different surface wetting indexes are prepared by changing the corona discharge conditions for PP film 4. The "surface wetting index" described in the present exemplary embodiment is defined in JIS K-6768.

Next, double surface vacuum deposited PP film 32 was manufactured by vacuum depositing aluminum and zinc on both sides of PP film 4 and spraying oxygen thereto by the method shown in Fig. 1. The PP film 4 used has a thickness of 6 µm and length of 2,000 m, maximum surface roughness Rmax = 1.3 µm, average surface roughness Ra = 0.15 µum, and an isotacticity of 97%, where the surface roughness is measured by the method specified in JIS B-0601. The deposited film peeling rates and an appearance of the product roll 3 were observed. The results are shown in Table 5.

**Table 5**

| Surface wetting index (dyn/cm) | | Peeling rate of deposited film | Appearance of product roll |
|---|---|---|---|
| Primary side | Secondary side | Innermost periphery of product roll | |
| 34 | 34 | 0.0 | Good |
| 37 | 37 | 0.0 | Good |
| 41 | 41 | 0.0 | Good |
| 33 | 33 | 0.8 | Good |
| 42 | 42 | 0.0 | Film wrinkling |
| 44 | 44 | Film breaking during vacuum deposition | Film breaking during vacuum deposition |

When the surface wetting index of the PP film 4 is less than 34 dyn/cm, the adhesion between deposited metal 31 and PP film 4 is lowered, and consequently, the peeling rate of the deposited film increases by 0.8 %. Also, when the surface wetting index exceeds 41 dyn/cm, the PP films 4 come in contact with each other in the raw material roll 2 and cannot be smoothly unwound, causing generation of wrinkling on the product roll 3 and breaking of the film. The surface wetting index of PP film can be set by changing the corona discharge condition or changing a time period from corona discharge until the vacuum deposition.

When the surface wetting indexes on both sides of the PP film 4 are in a range of 34 to 41 dyn/cm, there is no occurrence of the blocking, and moreover, the obtained double surface vacuum deposited PP film 32 shows good appearance on the product roll 3. Also, similar results are obtained with regard to the exemplary embodiment 2.

Next, in order to study the influences of the surface roughness of the PP film 4, PP films 4 having different surface roughness were manufactured, and double surface vacuum deposited PP film 32 are manufactured by vacuum depositing aluminum and zinc on both sides of the film and spraying oxygen thereto by the method shown in Fig. 1. The double surface vacuum deposited PP films 32 are cut by a slitter to observe the generation of wrinkling during the slitting operation. The results are shown in Table 6. The primary side and the secondary side mean the both sides of the PP film 32.

**Table 6**

| Maximum surface roughness Rmax (µm) | | Average surface roughness Ra (µm) | | Wrinkling due to slitting |
|---|---|---|---|---|
| Primary side | Secondary side | Primary side | Secondary side | |
| 1.75 | 1.72 | 0.16 | 0.18 | No |
| 1.54 | 1.46 | 0.14 | 0.14 | No |
| 1.12 | 1.08 | 0.10 | 0.11 | No |
| 1.05 | 0.90 | 0.10 | 0.08 | Occur |
| 0.91 | 0.92 | 0.09 | 0.08 | Occur |

When the maximum surface roughness Rmax is 1 µm or more and the average surface roughness Ra is 0.1 µm or more, the wrinkle during capacitor winding does not occur. Similar results are obtained in the exemplary embodiment 2.

Since metal is deposited on both sides of the double surface vacuum deposited PP film, if the surface roughness is less than the above value, the double surface vacuum deposited PP film will not smoothly move through many rollers disposed in the slitter (not shown) that slits the double surface vacuum deposited PP film to a predetermined width and in the film winding unit (not shown), causing the generation of the wrinkle and zigzag motion of the film. In a case Rmax exceeds 2.0 µm, the PP film will become uneven in thickness, and then, the PP film is liable to break at the thinnest portion when a voltage is applied to the capacitor manufactured. Therefore, Rmax is preferably to be 2.0 µm or less.

Further, in order to study the stereoregularity of the PP film 4, PP films 4 having different isotacticity are prepared. Product roll 3 of double surface vacuum deposited PP film 32 was manufactured by vacuum depositing aluminum and zinc on both sides of the PP films 4 and exposing it to oxygen gas by the method shown in Fig. 1. The product roll 3 was keft in an atmosphere of 40°C for 60 days to observe the degree of the blocking. The results are shown in Table 7.

**Table 7**

| Isotacticity (%) | Peeling rate of deposited metal (%) | |
|---|---|---|
| | 7 days after vacuum deposition | 60 days after vacuum deposition |
| 96 | 0.0 | 0.0 |
| 97 | 0.0 | 0.0 |
| 95 | 0.0 | 0.3 |

When the isotacticity of the PP film 4 is 95%, thermal shrinkage of double surface vacuum deposited PP film 32 occurs during 60 days keaping at 40°C, causing the product roll 3 to become gradually wound tightly, an occurrence of the blocking is observed, where the deposited metals 31 stick together and peel off each other. When the isotacticity is 96% or more, thermal shrinkage is hard to occur because the stereoregularity of the PP film 4 is enhanced, showing no occurrence of the blocking. Accordingly, when the isotacticity is 96% or more, it is possible to produce excellent double surface vacuum deposited PP film 32 having storageability wherein the film is free from blocking even when stored for a long period of time in a state of the product roll 3. Similar results are also obtained in the exemplary embodiment 2.

### INDUSTRIAL APPLICABILITY

As described above, according to the method of manufacturing double surface metallized film of the present invention, oxidizing gas is also wound into the product roll. Therefore, the oxidation of the vacuum deposited film occur even after the vacuum deposited insulating film has been wound up to the product roll, and sufficient oxide layer is formed on the surface of the deposited film. Thus, a double surface vacuum deposited film which is free from blocking even when a long insulating film is continuously vacuum deposited is obtained.

Also, according to the method of manufacturing of the present invention, an excellent double surface metallized film that is free from the occurrence of the blocking due to moisture even when the deposited film is stored for a long period of time or transported in a state of a product roll can be obtained, because of the oil layer formed on at least one side of the deposited film.

Further, according to the method of manufacturing of the present invention, since oxidizing gas gets into the product roll and oil layer is formed on at least one side of the film, an excellent double surface metallized film which is free from the occurrence of blocking due to moisture even when a long insulating film is continuously vacuum deposited is obtained.

Moreover, according to the method of manufacturing of the present invention, the blowout port for spraying oxidizing gas moves in accordance with the radius of the product roll that increases during the vacuum deposition. In this way, the oxidizing gas can be sprayed from a constant distance during the operation from the start of the vacuum deposition when the product roll is smaller in diameter until the end of the vacuum deposition when the product roll is increased in diameter. Accordingly, a double surface metallized film of uniform quality even when a long film is continuously vacuum deposited is obtained.

Further, according to the manufacturing method of the present invention, oxygen is used as an oxidizing gas, and therefore, it is possible to minimize the deteriorating of degree of vacuum due to the oxidizing gas.

Further, according to the method of manufacturing double surface metallized film of the present invention, chemically stable silicone oil or fluoro-carbon oil is used as oil for forming oil layer. Accordingly, an excellent double surface vacuum deposited film which is free from peeling of the deposited film and free from an increase of resistance due to a permeation or a swelling of the oil into the insulating film can be obtained.

Further, according to the method of manufacturing double surface metallized film of the present invention, oil layer is formed on only a predetermined portion in the widthwise direction of the film. Thus, a double surface vacuum deposited film which is excellent in adhesiont with the metallikon is obtained.

Further, according to the method of manufacturing double surface metallized film of the present invention, since oil vapor is sprayed to the film under a non-contact condition, a double surface deposited film without scratching on the deposited film can be obtained.

Further, according to the method of manufacturing double surface metallized film of the present invention, oil vapor is sprayed to the deposited film while monitoring the oil vapor pressure by a pressure sensor disposed in the oil tank. Thus, an oil layer is formed on a long film at a constant rate.

Further, according to the method of manufacturing double surface metallized PP film of the present invention, since the surface wetting index of the PP film is set to be 34 to 41 dyn/cm for both sides thereof, an excellent double surface vacuum deposited PP film which is excellent in adhesion between the deposited metal and the PP film, and also, is free from a problem such that the PP films stick to each other in the raw material roll is obtained.

Further, according to the method of manufacturing double surface metallized PP film of the present invention, the surface roughness on at least one side of the PP film is set to be the maximum roughness Rma of 1.0 to 2.0 µm, and the average roughness Ra of 0.1 µm or more. Accordingly, there is no trouble such as a generation of wrinkle and zigzag movement in the next step of slitting or winding, and an double surface vacuum deposited PP film of excellent workability is obtained.

Further, according to the method of manufacturing double surface metallized PP film of the present invention, PP film of isotacticity of 96% or more is used. Since the stereoregularity of crystal of the PP film is enhanced, the elastic modulus of the PP film is improved, and as a result, the tightning during the winding of the product roll can be decrreased. Accordingly, it is possible to obtain a double surface vacuum deposited PP film which has excellent characteristics with respect to storage and transportation when the film is stored for a long period of time or transported in a state of product roll.

Further, in the process of a metallized film capacitor of the present invention, only one step of the vacuum deposition is required, and a low-cost capacitor having excellent electrical characteristics is obtained.

## Claims

1. A method of manufacturing double metallized film, including the steps of:
vacuum depositing zinc or zinc-aluminum mixture on both sides of an insulating film (103) so as to form a first deposited film (121) and a second deposited film (121);
spraying an oxidizing gas to at least the first deposited film, thereby forming an oxide layer on at least the first deposited film; and
winding said insulating film (103) around a product roll so that the first deposited film is on a side of an inner surface;
**characterized by** the step of
forming an oil layer (129) on at least one of the first and second deposited films (121);
wherein said oxide layer is formed by spraying oxidizing gas to the first deposited film (121) at the final winding step of said vacuum deposited insulating film around the product roll.

2. The method of manufacturing double metallized film of claim 1, wherein an vacuum deposition apparatus has a blowout port (9) for spraying the oxidizing gas, and said blowout port moves in accordance with a radius of the product roll (3) that increases a size during winding.

3. The method of manufacturing double metallized film of claim 1 or 2, wherein said oxidizing gas is one of oxygen and air.

4. The method of manufacturing double metallized film of any one of claim 1 through claim 3, wherein an oil to form said oil layer is one of silicone oil and fluoro-carbon oil.

5. The method of manufacturing double metallized film of claim 1, wherein said oil layer is formed by spraying oil vapor to one of the first and second deposited films.

6. The method of manufacturing double metallized film of claim 5, wherein said oil layer is formed only on a predetermined portion in a widthwise direction of said insulating film.

7. The method of manufacturing double metallized film of claim 5, wherein said oil vapor is sprayed to one of the first and second deposited films while monitoring oil vapor pressure using a pressure sensor (127) disposed in an oil tank (120).

8. The method of manufacturing double metallized film of any one of claim 1 through claim 7, wherein said insulating film is a polypropylene film.

9. The method of manufacturing double metallized film of claim 8, wherein a surface wetting index of both surface of said polypropylene film is 34 - 41 dyn/cm, where said surface wetting index is defined in JIS K-6768.

10. The method of manufacturing double metallized film of claim 8, wherein at least one side of said polypropylene film has a surface roughness Rmax of 1.0 - 2.0 µm and Ra of 0.1 µm or more, where Rmax is a maximum surface roughness and Ra is an average surface roughness, both defined by a method specified in JIS B-0601.

11. The method of manufacturing double metalized film of one of claims 1 to 11, further comprising the step of:
manufacturing a metallized film capacitor by winding the vacuum deposited insulating film, wound around the product roll, and a laminating insulating film.

## Patentansprüche

1. Verfahren zum Herstellen einer doppelt metallisierten Folie, das die folgenden Schritte einschließt:
Aufdampfen von Zink oder Zink-Aluminium-Gemisch auf beide Seiten einer isolierenden Folie (103), um einen ersten aufgedampften Film (121) und einen zweiten aufgedampften Film (121) auszubilden;
Blasen eines oxidierenden Gases wenigstens auf den ersten aufgedampften Film, um so eine Oxidschicht wenigstens auf dem ersten aufgedampften Film auszubilden; und
Wickeln der isolierenden Folie (103) um eine Erzeugnisrolle herum, so dass sich der erste aufgedampfte Film an einer Seite einer Innenfläche befindet;
**gekennzeichnet durch** den folgenden Schritt:
Ausbilden einer Ölschicht (129) auf dem ersten oder/und dem zweiten aufgedampften Film (121);
wobei die Oxidschicht ausgebildet wird, indem in dem abschließenden Schritt des Wickelns der bedampften isolierenden Folie um die Erzeugnisrolle herum oxidierendes Gas auf den ersten aufgedampften Film (121) geblasen wird.

2. Verfahren zum Herstellen einer doppelt metallisierten Folie nach Anspruch 1, wobei eine Aufdampfvorrichtung eine Ausblasöffnung (9) zum Aufblasen des oxidierenden Gases aufweist und sich die Ausblasöffnung entsprechend einem Radius der Erzeugnisrolle (3) bewegt, deren Größe beim Wickeln zunimmt.

3. Verfahren zum Herstellen einer doppelt metallisierten Folie nach Anspruch 1 oder 2, wobei das oxidierende Gas Sauerstoff oder Luft ist.

4. Verfahren zum Herstellen einer doppelt metallisierten Folie nach einem der Ansprüche 1 bis 3, wobei ein Öl zum Ausbilden der Ölschicht Silikonöl oder Fluorkarbonöl ist.

5. Verfahren zum Herstellen einer doppelt metallisierten Folie nach Anspruch 1, wobei die Ölschicht ausgebildet wird, indem Öldampf auf den ersten oder den zweiten aufgedampften Film gesprüht wird.

6. Verfahren zum Herstellen einer doppelt metallisierten Folie nach Anspruch 5, wobei die Ölschicht nur auf einem vorgegebenen Abschnitt in einer Breitenrichtung der isolierenden Folie ausgebildet wird.

7. Verfahren zum Herstellen einer doppelt metallisierten Films nach Anspruch 5, wobei der Öldampf auf den ersten oder den zweiten aufgedampften Film aufgesprüht wird und dabei Öldampfdruck unter Verwendung eines Drucksensors (127) überwacht wird, der in einem Ölbehälter (120) angeordnet ist.

8. Verfahren zum Herstellen einer doppelt metallisierten Folie nach einem der Ansprüche 1 bis 7, wobei die isolierende Folie eine Polypropylen-Folie ist.

9. Verfahren zum Herstellen einer doppelt metallisierten Folie nach Anspruch 8, wobei ein Oberflächen-Benetzungsindex beider Oberflächen der Polypropylen-Folie 34 - 41 dyn/cm beträgt und der Oberflächen-Benetzungsindex in JIS K-6767 definiert ist.

10. Verfahren zum Herstellen einer doppelt metallisierten Folie nach Anspruch 8, wobei wenigstens eine Seite der Polypropylen-Folie eine Oberflächenrauigkeit Rmax von 1,0 - 2,0 µm und Ra von 0,1 µm oder mehr hat, wobei Rmax eine maximale Oberflächenrauigkeit ist und Ra eine durchschnittliche Oberflächenrauigkeit ist, die beide nach einer in JIS B-0601 spezifizierten Methode definiert sind.

11. Verfahren zum Herstellen einer doppelt metallisierten Folie nach einem der Ansprüche 1 bis 11, das des Weiteren den folgenden Schritt umfasst:
Herstellen eines metallisierten Folienkondensators durch Wickeln der bedampften isolierenden Folie, die um die Erzeugnisrolle herum gewickelt ist, und einer abdeckenden isolierenden Folie.

## Revendications

1. Procédé de fabrication d'un film doublement métallisé, incluant les étapes consistant à :
déposer sous vide du zinc ou un mélange de zinc et d'aluminium sur les deux côtés d'un film isolant (103) de façon à former un premier film à dépôt (121) et un second film à dépôt (121),
pulvériser un gaz oxydant sur au moins le premier film à dépôt, ce qui forme de ce fait une couche d'oxyde sur au moins le premier film à dépôt, et
bobiner ledit film isolant (103) autour d'un rouleau de produit de telle sorte que le premier film se trouve sur le côté de la surface interne,
**caractérisé par** l'étape consistant à
former une couche d'huile (129) sur au moins l'un des premier et second films à dépôt (121),
dans lequel ladite couche d'oxyde est formée en pulvérisant un gaz oxydant sur le premier film à dépôt (121) lors de l'étape finale de bobinage dudit film isolant à dépôt sous vide autour du rouleau de produit.

2. Procédé de fabrication d'un double film métallisé selon la revendication 1, dans lequel un appareil de dépôt sous vide possède un port de soufflage (9) permettant de pulvériser le gaz oxydant, et ledit port de soufflage se déplace en fonction du rayon du rouleau de produit (3) qui augmente de taille pendant le bobinage.

3. Procédé de fabrication d'un double film métallisé selon la revendication 1 ou 2, dans lequel ledit gaz oxydant est l'un de l'oxygène et de l'air.

4. Procédé de fabrication d'un double film métallisé selon l'une quelconque des revendications 1 à 3, dans lequel l'huile destinée à former ladite couche d'huile est l'une d'une huile de silicone et d'une huile de fluorocarbone.

5. Procédé de fabrication d'un double film métallisé selon la revendication 1, dans lequel ladite couche d'huile est formée en pulvérisant de la vapeur d'huile sur l'un des premier et second films à dépôt.

6. Procédé de fabrication d'un double film métallisé selon la revendication 5, dans lequel ladite couche d'huile n'est formée que sur une partie prédéterminée dans la direction de la largeur dudit film isolant.

7. Procédé de fabrication d'un double film métallisé selon la revendication 5, dans lequel ladite vapeur d'huile est pulvérisée sur l'un des premier et second films à dépôt tout en surveillant la pression de vapeur d'huile en utilisant un capteur de pression (127) placé dans un réservoir d'huile (120).

8. Procédé de fabrication d'un double film métallisé selon l'une quelconque des revendications 1 à 7, dans lequel ledit film isolant est un film de polypropylène.

9. Procédé de fabrication d'un double film métallisé selon la revendication 8, dans lequel l'indice de mouillage de surface des deux surfaces dudit film de polypropylène est de 34 à 41 dyn / cm, où ledit indice de mouillage de surface est défini dans la norme JIS K - 6768.

10. Procédé de fabrication d'un double film métallisé selon la revendication 8, dans lequel au moins un côté dudit film de polypropylène présente une rugosité de surface Rmax de 1,0 à 2,0 µm et une rugosité Ra de 0,1 µm ou plus, où Rmax et la rugosité maximale de surface et où Ra est la rugosité moyenne de surface, les deux étant définies par un procédé spécifié dans la norme JIS B - 0601.

11. Procédé de fabrication d'un double film métallisé selon l'une quelconque des revendications 1 à 11, comprenant en outre l'étape consistant à :
fabriquer un condensateur à film métallisé en bobinant le film isolant à dépôt sous vide autour du rouleau de produit ainsi qu'un film isolant de stratification.
